# EUROPÄISCHE PATENTSCHRIFT

(11) **EP 0 856 945 B1**
(45) Veröffentlichungstag und Bekanntmachung des Hinweises auf die Patenterteilung: **10.04.2002**
(21) Anmeldenummer: 98101129.9
(22) Anmeldetag: 23.01.1998
(51) Int. Cl.: H03K 17/955, H03K 17/96, G08B 13/26

(54) **Annäherungssensor oder Berührungsschalter oder Bruchschalter oder dergleichen**
Proximity sensor or touch switch or breaking switch or the like
Capteur de proximité ou commutateur à effleurement ou commutateur de rupture ou similaire

(30) Priorität: 01.02.1997 DE 19703844
(43) Veröffentlichungstag der Anmeldung: 05.08.1998
(73) Patentinhaber: arcon Flachglas-Veredelungs GmbH & Co. Beschichtungstechnik KG, 91555 Feuchtwangen (DE)
(72) Erfinder: Söder, Bernhard, Dr.,Dipl.-Phys., 91639 Wolframs-Eschenbach (DE)
(74) Vertreter: Dreiss, Fuhlendorf, Steimle & Becker

(56) Entgegenhaltungen:
- WO-A-94/24645
- DE-C- 4 327 664
- US-A- 4 692 744

## Beschreibung

Die Erfindung betrifft eine Vorrichtung für einen Annäherungssensor oder einen Berührungsschalter oder einen Bruchschalter nach dem Oberbegiff der Anspruch 1.

Derartige Annäherungssensoren oder Berührungsschalter sind aus der WO-A-94 24 645 bekannt und werden auch oft als kapazitive Näherungsschalter bezeichnet. Sie werden beispielsweise in Wasserhähnen oder Urinalen zum automatischen Ein- und Ausschalten der Wasserzufuhr verwendet.

Die bekannten kapazitiven Näherungsschalter enthalten einen Schwingkreis mit einem Kondensator. Eine der beiden Elektroden des Kondensators ist als sogenannte aktive Fläche ausgebildet, die ein elektrisches Feld in die Umgebung des Nährungsschalters abstrahlt. Dies kann z.B. mit einer auf einer Glasscheibe aufgebrachten, elektrisch leitfähigen Schicht erreicht werden. Die andere Elektrode wird üblicherweise von dem als Masse wirkenden Boden oder sonstigen geerdeten Gegenständen in der Umgebung des Nährungsschalters gebildet. Durch einen in das abgestrahlte elektrische Feld eintretenden Menschen wird die Kapazität des Kondensators verändert und der Schwingkreis verstimmt. Dies wird durch eine elektrische Schlatung dergestalt ausgewertet , daß bei Erreichen eines vorgebbaren Grenzwertes der Verstimmung ein nachgeordneter Schalter umgeschaltet wird. Durch den umgeschalteten Schalter wird dann beispielsweise ein Ventil für die Wasserzufuhr in dem Wasserhahn oder dem Urinal geöffnet.

Aufgabe der Erfindung ist es, derartige kapazitive Näherungsschalter zu verbessern und insbesondere deren Einsatzmöglichkeiten zu erweitern.

Diese Aufgabe wird erfindungsgemäß durch eine Vorrichtung nach dem Anspruch 1 gelöst.

Bei zwei derart parallel angeordneten Scheiben kann es sich beispielsweise um ein doppelt verglastes Fenster, insbesondere ein Isolierglasfenster oder dergleichen handeln. Häufig ist bei derartigen Fenstern der Scheibenzwischenraum zum Zwecke einer besseren Wärmeisolation mit Edelgas gefüllt. Gleichzeitig ist bei diesen Fenstern eine Sonnen- und/oder Wärmeschutzschicht im Scheibenzwischenraum vorgesehen. Damit auch in diesem Fall die Schicht als Elektrode des kapazitiven Näherungsschalters verwendet werden kann, ist auf der anderen Seite der mit der Schicht versehenen Scheibe eine elektrisch leitfähige Fläche vorgesehen. Diese bildet mit der elektrisch leitfähigen Schicht einen weiteren Kondensator, der mit dem in die Umgebung abstrahlenden elektrischen Feld eine Serienschaltung bildet. Mit Hilfe der elektrisch leitfähigen Fläche ist es somit möglich, eine elektrische Kopplung der Schicht herzustellen. Der wesentliche Vorteil besteht dabei darin, daß der gasgefüllte Scheibenzwischenraum nicht zum Herausführen einer elektrischen Leitung oder dergleichen geöffnet werden muss. Des weiteren kann eine bei einem derartigen Fenster vorhandene Schicht damit auch noch nachträglich als Elektrode eines kapazitiven Näherungsschalters eingesetzt werden.

Bei einer vorteilhaften Weiterbildung der Erfindung ist als Schicht eine Sonnenschutzschicht oder eine Wärmeschutzschicht oder dergleichen vorgesehen. Dadurch ist es möglich, die für Glas bekannten Sonnenschutzschichten oder Wärmeschutzschichten zu verwenden. Dabei handelt es sich insbesondere um Aufdampfverfahren oder Sputterverfahren, bei denen das Glas danach immer noch transparent erscheint. Die Verwendung von derart mit einer Schicht versehenem Glas hat auch vorteilhafte Auswirkungen auf das äußere Erscheinungsbild des Näherungsschalters.

Durch diese Maßnahme wird erreicht, daß die Scheibe mit der aufgebrachten Schicht ein Bestandteil des kapazitiven Nährungsschalters wird. Es wird somit ein Nährungsschalter geschaffen, dessen das elektrische Feld in die Umgebung abstrahlende Elektrode von der auf der Scheibe aufgebrachten Schicht gebildet wird. Dadurch ist es möglich, die Fläche dieser Elektrode durch eine entsprechende Ausgestaltung der Scheibe wesentlich größer vorzusehen als bei bekannten Nährungsschaltern. Dies hat vorteilhafte Folgen auf die Fähigkeit des Nährungsschalters, beispielsweise einen sich annähernden Menschen möglichst frühzeitig zu erkennen. Des weiteren wird durch eine vergrößerte Fläche der das elektrische Feld abstrahlenden Elektrode die Funktionssicherheit bei der Erkennung eines sich annähernden Menschen wesentlich erhöht.

Des weiteren wird durch die Verwendung der auf der Scheibe aufgebrachten Schicht die Herstellung des Näherungsschalters vereinfacht und gleichzeitig flexibler gestaltet. Derartige Scheiben können nach bekannten Verfahren kostengünstig in großer Menge hergestellt werden, so daß es danach nur noch erforderlich ist, die für den Näherungsschalter gewünschte Fläche aus der Scheibe auszuschneiden und in der gewünschten Art und Weise einzubauen.

Des weiteren eröffnen sich dem erfindungsgemäßen Näherungsschalter durch die Verwendung des Scheibe völlig neue Einsatzmöglichkeiten. So ist es möglich, als Scheibe eine Fensterscheibe vorzusehen, wodurch der Näherungsschalter als Alarmsensor zur Gebäudesicherung oder dergleichen eingesetzt werden kann. Ebenfalls ist es möglich, die Scheibe als Diebstahlschutz in einer Vitrine oder dergleichen einzubauen, hinter der beispielsweise Kunstgegenstände ausgestellt sind.

Bei einer vorteilhaften Ausgestaltung der Erfindung besteht die Scheiben aus Glas oder aus Einscheibensicherheitsglas.

Bei einer weiteren vorteilhaften Ausgestaltung der Erfindung ist die Scheibe ein Bestandteil eines Fensters. Auf diese Weise wird ein völlig andersartiger kapazitiver Näherungsschalter geschaffen. Die gesamte Fensterfläche bildet in diesem Fall die Elektrode des Kondensators. Damit kann erreicht werden, daß der Nährungsschalter extrem frühzeitig beispielsweise einen sich annähernden Menschen erkennen kann. Gleichzeitig ist der Nährungsschalter für einen Betrachter praktisch nicht erkennbar, da die auf der Scheibe des Fensters aufgebrachte Sonnenschutzschicht oder Wärmeschutzschicht transparent ist und im übrigen auch nicht als Näherungsschalter realisiert wird. Dies eröffnet die Möglichkeit, den Näherungsschalter auch als Bruchschalter oder Alarmsensor oder dergleichen beispielsweise zur Absicherung eines Hauses zu verwenden.

Dabei hat die Erfindung den wesentlichen Vorteil, dass im Unterschied zu den bekannten Bruchschaltern, bei denen eine sichere Alarmauslösung nur bei Verwendung von Einscheibensicherheitsglas gewährleistet ist, der erfindungsgemäße Bruchschalter auch zusammen mit beispielweise Flachglas sicher einsetzbar ist. Bei einer Zerstörung der Fensterscheibe wird das von der elektrisch leitfähigen Schicht ausgestrahlte elektrische Feld in jedem Fall verändert und der Alarm kann sicher ausgelöst werden.

Daraus ergibt sich die vorteilhafte Wahlmöglichkeit, daß eine elektrische Leitung an die elektrisch leitfähige Fläche angeschlossen werden kann. Über die Leitung ist dann die Schicht mit der übrigen elektrischen Schaltung des Näherungsschalters, also beispielsweise mit dem Schwingkreis verbunden.

Besonders zweckmäßig ist es dabei, wenn die elektrische Leitung vor einem unbefugten Zugriff geschützt ist. Dadurch wird erreicht, daß insbesondere bei der Verwendung des kapazitiven Näherungsschalters als Alarmsensor die Funktionsfähigkeit der gesamten Schaltung nicht durch ein einfaches unbefugtes Durchtrennen der elektrischen Leitung zerstört werden kann.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.
- Figur 1: zeigt zu Illustrationszwechen eine schematische, teilweise geschnittene Seitenansicht eines Annäherungssensors, und
- Figur 2: zeigt eine schematische, teilweise geschnittene Seitenansicht einer ersten Ausführungsform einer erfindungsgemäßen Vorrichtung.

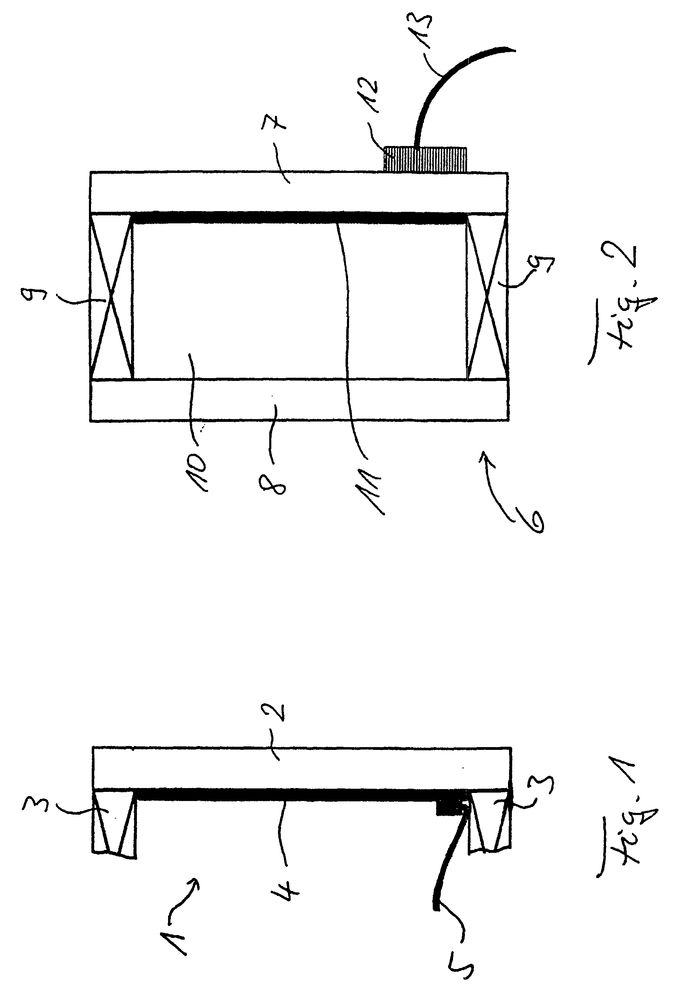

Figur 1 zeigt eine Vorrichtung 1, die mit einer aus Glas bestehenden Scheibe 2 versehen ist. Die Scheibe 2 ist in einem Rahmen 3 oder dergleichen eingebaut. Auf der dem Rahmen 3 zugewandten Seite der Scheibe 2 ist eine elektrisch leitfähige Schicht 4 auf die Scheibe 2 aufgebracht, bei der es sich beispielsweise um eine Sonnenschutzschicht oder um eine Wärmeschutzschicht oder dergleichen handeln kann. Am Rand der Schicht 4 in unmittelbarer Nähe des Rahmens 3 ist an die Schicht 4 eine elektrische Leitung 5 mittels einer Lötung oder Verklebung oder dergleichen angeschlossen.

Die Schicht 4 bildet eine Elektrode eines Kondensators. Der Kondensator ist ein Bestandteil einer elektrischen Schaltung, bei der es sich beispielsweise um einen Schwingkreis handeln kann.

Von der Schicht 4 wird im eingeschalteten Betriebszustand ein elektrisches Feld in die Umgebung der Scheibe 2 abgestrahlt. Wird dieses elektrische Feld beispielsweise durch einen in den Bereich der Scheibe eindringenden Gegenstand, beispielsweise einen Menschen gestört, so wird dadurch der Schwingkreis verstimmt.

Die elektrische Schaltung ist derart ausgestaltet, daß sie die Verstimmung erkennen und bei Erreichen einer bestimmten Verstimmung beispielsweise einen Schalter umschalten kann. Mit diesem Schalter können dann beliebige nachgeordnete Funktionen beeinflußt werden.

Bei der Scheibe 2 der Vorrichtung 1 kann es sich um die Glasscheibe eines Fensters handeln. Es ist aber auch möglich, daß die Scheibe 2 ein Bestandteil einer Vitrine oder dergleichen ist.

Wird die Vorrichtung 1 beispielsweise in einem Näherungssensor einer Vitrine eingesetzt, so kann durch den Schalter beispielsweise eine Warnlampe oder ein akustisches Signal eingeschaltet werden, um auf die Annäherung des Menschen hinzuweisen. Dies kann zum Schutz beispielsweise von Kunstgegenständen verwendet werden, die in der Vitrine ausgestellt sind.

Wird die Vorrichtung 1 als Berührungsschalter beispielsweise in einem Fenster eingesetzt, so kann durch den Schalter beispielsweise ein elektrischer Motor für einen Rolladen oder dergleichen eingeschaltet werden.

In der Figur 2 ist eine Vorrichtung 6 dargestellt, die zwei parallel zueinander angeordnete, aus Glas bestehende Scheiben 7, 8 aufweist. Die Scheiben 7, 8 sind in einem Rahmen 9 dicht und fest gehalten. Der Scheibenzwischenraum 10 zwischen den beiden Scheiben 7, 8 ist beispielsweise mit Edelgas gefüllt.

Auf der dem Scheibenzwischenraum 10 zugewandten Seite der Scheibe 7 ist diese mit einer elektrisch leitfähigen Schicht 11 versehen, bei der es sich beispielsweise um eine Sonnenschutzschicht oder um eine Wärmeschutzschicht handeln kann. Am Rand der Schicht 11 in unmittelbarer Nähe des Rahmens 9 ist auf der dem Scheibenzwischenraum 10 abgewandten Seite der Scheibe 7 eine elektrisch leitfähige Fläche 12 aufgebracht. Bei der Fläche 12 kann es sich beispielsweise um eine auf die Scheibe 7 aufgeklebte Metallschicht oder dergleichen handeln. An diese Fläche 12 ist eine elektrische Leitung 13 angeschlossen.

Die Schicht 11 der Figur 2 bildet wie die Schicht 4 der Figur 1 eine der beiden Elektroden eines Kondensators. Es wird insoweit auf die Ausführungen zur Figur 1 verwiesen.

Bei den beiden Scheiben 7, 8 der Vorrichtung 6 kann es sich um die Glasscheiben eines Isolierglasfensters handeln. In diesem Fall kann die Vorrichtung 6 beispielsweise als Näherungssensor verwendet werden. Dringt beispielsweise ein Mensch in das von der Schicht 11 abgestrahlte elektrische Feld ein, so ändert sich dadurch nicht nur dieses abgestrahlte elektrische Feld, sondern auch das zwischen der Schicht 11 und der elektrisch leitfähigen Fläche 12 bestehende elektrische Feld. Die beiden elektrischen Felder gehören dabei zu zwei Kondensatoren, die eine Serienschaltung bilden. Beide Kondensatoren sind Bestandteile beispielsweise eines Schwingkreises, so daß durch die Veränderung der elektrischen Felder dieser Schwingkreis verstimmt wird. Wie bereits erläutert, kann dies von einer elektrischen Schaltung ausgewertet und zum Auslösen der erwünschten Funktionen verwendet werden. Im vorliegenden Fall kann dann beispielsweise ein optisches oder akustisches Signal abgegeben werden, um auf die Annäherung eines Menschen hinzuweisen.

Wird die Vorrichtung 1 der Figur 1 oder die Vorrichtung 6 der Figur 2 zum Schutz beispielsweise von Gebäuden oder dergleichen vewendet, dann sollte die elektrische Leitung 5 bzw. 13 in irgendeiner Weise vor unbefugtem Zugriff geschützt verlegt sein. So ist es beispielsweise bei der Vorrichtung 1 der Figur 1 möglich, die Leitung 5 auf der Seite des Rahmens 3, also beispielsweise im Inneren einer Vitrine zu verlegen. Damit ist die Leitung 5 nicht zugänglich. Erst durch die Zerstörung der Scheibe 2 könnte die Leitung 5 beispielsweise durchtrennt werden. Eine derartige Zerstörung der Scheibe 2 hätte aber sofort eine völlige Verstimmung des Schwingkreises und damit die Erzeugung eines Alarmsignals zur Folge. Entsprechende Möglichkeiten sind auch bei der Vorrichtung 6 der Figur 2 denkbar.

Bei den anhand der Figuren 1 und 2 beschriebenen Ausführungsbeispielen ist es auch möglich, dass die Scheibe 2, 7 aus Einscheibensicherheitsglas besteht. In diesem Fall kann die gesamte Vorrichtung 1, 6 derart eingestellt werden, dass sie nicht auf Annäherung reagiert, sondern auf den Bruch der Scheibe 2, 7. Wird also die Scheibe 2, 7 zum Beispiel bei einem Einbruch zerstört, so wird durch die Vorrichtung 1, 6 sicher ein Alarm ausgelöst. Die Vorrichtung 1, 6 stellt somit in diesem Fall einen Bruchschalter dar.

## Patentansprüche

1. Vorrichtung (6) für einen Annäherungssensor oder einen Berührungsschalter oder einen Bruchschalter mit einem ersten vorzugsweise in einen Schwingkreis eingebundenen Kondensator, dessen eine Elektrode durch die Umgebung des Annäherungssensors bzw. des Berührungsschalters gebildet ist, und dessen andere Elektrode von einer auf einer Scheibe (7) aufgebrachten elektrisch leitfähigen Schicht (11) gebildet ist, **dadurch gekennzeichnet, daß** zwei zueinander parallele Scheiben (7, 8) vorgesehen sind, daß die elektrisch leitfähige Schicht (11) auf der dem Scheibenzwischenraum (10) zugewandten Seite einer der beiden Scheiben (7) aufgebracht ist, und daß auf der dem Scheibenzwischenraum (10) abgewandten Seite der mit der Schicht (11) versehenen Scheibe (7) eine elektrisch leitfähige Fläche (12) vorgesehen ist, die zusammen mit der leitfähigen Schicht (11) einen zum ersten seriengeschalteten zweiten Kondensator bildet.

2. Vorrichtung (6) nach Patentanspruch 1, **dadurch gekennzeichnet, dass** als Schicht (11) eine Sonnenschutzschicht oder eine Wärmeschutzschicht oder dergleichen vorgesehen ist.

3. Vorrichtung (6) nach Patentanspruch 1 oder 2, **dadurch gekennzeichnet, daß** die Scheiben (7, 8) aus Glas bestehen.

4. Vorrichtung (6) nach Patentanspruch 1 oder 2, **dadurch gekennzeichnet, daß** die Scheiben (7, 8) aus Einscheibensicherheitsglas bestehen.

5. Vorrichtung (6) nach einem der Patentansprüche 3 oder 4, **dadurch gekennzeichnet, daß** die Scheiben (7, 8) ein Bestandteil eines Fensters sind.

6. Vorrichtung (6) nach einem der Patentansprüche 1 bis 5, **dadurch gekennzeichnet, daß** an die elektrisch leitfähige Fläche (12) eine elektrische Leitung (13) angeschlossen ist.

7. Vorrichtung (6) nach Patentanspruch 6, **dadurch gekennzeichnet, daß** die elektrische Leitung (13) vor einem unbefugten Zugriff geschützt ist.

## Claims

1. Device (6) for a proximity sensor or a contact switch or a break switch with a first capacitor, preferably incorporated in an oscillating circuit, the one electrode of which is formed by the surroundings of the proximity switch or of the contact switch and the other electrode of which is formed by an electrically conductive layer (11) applied to a sheet (7), **characterised in that** two mutually parallel sheets (7, 8) are provided, **in that** the electrically conductive layer (11) is applied to the side of one of the two sheets (7) facing the space (10) between the sheets, and **in that** an electrically conductive face (12), which together with the conductive layer (11) forms a second capacitor connected in series to the first, is provided on the side of the sheet (7) provided with the layer (11) remote from the space (10) between the sheets.

2. Device (6) according to claim 1, **characterised in that** a sun protection layer or a heat protection layer or the like is provided as layer (11).

3. Device (6) according to claim 1 or 2, **characterised in that** the sheets (7, 8) consist of glass.

4. Device (6) according to claim 1 or 2, **characterised in that** the sheets (7, 8) consist of toughened safety glass.

5. Device (6) according to any of claims 3 or 4, **characterised in that** the sheets (7, 8) are a component of a window.

6. Device (6) according to any of claims 1 to 5, **characterised in that** an electric lead (13) is connected to the electrically conductive face (12).

7. Device (6) according to claim 6, **characterised in that** the electric lead (13) is protected against unauthorised access.

## Revendications

1. Dispositif (6) destiné à un capteur de proximité, un commutateur à effleurement, un commutateur à rupture ou analogue, comportant un premier condensateur qui est branché, de préférence, dans un circuit oscillant, dont l'une des électrodes est constituée par l'environnement du capteur de proximité ou du commutateur à effleurement et dont l'autre électrode est constituée par une couche électriquement conductrice (11) déposée sur un disque (7), **caractérisé en ce que** l'on prévoit deux disques (7, 8) parallèles l'un à l'autre, **en ce que** la couche électriquement conductrice (11) est déposée sur la face de l'espace délimité par les disques (10) qui fait face à l'un des deux disques (7) et **en ce que**, sur la face du disque (7) muni de la couche (11) qui est opposée à l'espace délimité par les disques (10), on prévoit une surface électriquement conductrice (12) qui constitue, avec la couche électriquement conductrice (11), un deuxième condensateur qui est branché en série avec le premier condensateur.

2. Dispositif (6) selon la revendication 1, **caractérisé en ce que**, en tant que couche (11), on prévoit une couche de protection contre le rayonnement du soleil, une couche de protection contre la chaleur ou analogue.

3. Dispositif (6) selon la revendication 1 ou 2, **caractérisé en ce que** les disques (7, 8) sont constitués par du verre.

4. Dispositif (6) selon la revendication 1 ou 2, **caractérisé en ce que** les disques (7, 8) sont constitués par du verre de sécurité trempé.

5. Dispositif (6) selon l'une des revendications 3 ou 4, **caractérisé en ce que** les disques (7, 8) constituent un élément constitutif d'une fenêtre.

6. Dispositif (6) selon l'une quelconque des revendications 1 à 5, **caractérisé en ce qu'**une ligne électrique (13) est reliée à la surface électriquement conductrice (12).

7. Dispositif (6) selon la revendication 6, **caractérisé en ce que** la ligne électrique (13) est protégée contre un accès non autorisé.
